# EUROPÄISCHE PATENTSCHRIFT

(11) **EP 0 336 114 B1**
(45) Veröffentlichungstag und Bekanntmachung des Hinweises auf die Patenterteilung: **08.09.1993**
(21) Anmeldenummer: 89103689.9
(22) Anmeldetag: 02.03.1989
(51) Int. Cl.: H05K 13/02

(54) **Vorrichtung zur Lageerfassung der Anschlusskontakte elektrischer oder elektronischer Bauelemente**
Apparatus for detecting the position of contacts of electric or electronic components
Dispositif de détection de la position des plots de contact de composants électriques ou électroniques

(30) Priorität: 08.04.1988 DE 8804665 U
(43) Veröffentlichungstag der Anmeldung: 11.10.1989
(73) Patentinhaber: SIEMENS AKTIENGESELLSCHAFT, 80333 München (DE)
(72) Erfinder: Grasmüller, Hans-Horst, D-8083 Mammendorf (DE); Moritz, Harald, D-8000 München 2 (DE)

(56) Entgegenhaltungen:
- EP-A- 0 234 904
- GB-A- 2 189 719

## Beschreibung

Die Erfindung betrifft eine Vorrichtung zur Lageerfassung der Anschlußkontakte elektrischer oder elektronischer Bauelemente, insbesondere von SMD-Bauelementen in automatischen Bestückstationen.

Bei der automatischen Bestückung von Leiterplatten oder Keramiksubstraten mit oberflächenmontierbaren elektronischen Bauelementen die meist als SMD-Bauelemente bezeichnet werden, werden diese aus entsprechenden Vorratsmagazinen mit der Saugpipette eines Bestückkopfes entnommen, genau über die vorgegebene Bestückposition transportiert und dann auf der Leiterplatte oder dem Keramiksubstrat abgesetzt. Dabei ist es für die Präzision der Bestückung von entscheidender Bedeutung eventuelle Verdrehungen oder Verschiebungen der Bauelemente zu erfassen und vor dem Absetzen auf der vorgegebenen Bestückposition zu korrigieren.

Aus der US-PS 3 337 941 ist eine gattungsgemäße Vorrichtung zur Lageeerkennung der Anschlußkontakte elektronischer Bauelemente bekannt, bei welcher die Lageerfassung durch Abtasten der Anschlußkontakte auf der Unterseite der Bauelemente vorgenommen wird. Mit zunehmender Miniatuisierung der Bauelemente und steigender Anzahl der Anschlußkontakte eines Bauelements ist eine derartige Lageerfassung der Anschlußkontakte jedoch nicht mehr möglich.

Aus der DE-OS 3 340 084 ist auch bereits eine Vorrichtung zur Lageerfassung elektronischer Bauelemente bekannt, bei welcher die effektive Lage der Bauelemente durch Abtastung mittels eines Laserstrahls nach dem Reflexions- oder Abschattungsprinzip ermittelt wird. Auch hier werden dann entsprechende Korrektursignale ausgewertet um den Transportweg des Bestückkopfes und/oder die Lage der Leiterplatte bzw. die Lage des Keramiksubstrats im Sinne einer Korrektur zu beeinflussen.

Eine Betrachtung der Strukturen elektronischer Bauelemente im Durchlichtverfahren führt zu einer eingeschränkten Bauelementebeurteilung. Außerdem sind Bauelemente mit im Durchlichtverfahren nicht sichtbaren Strukturdetails grundsätzlich nicht auswertbar.

Vorrichtungen zut Lageerfassung im Auflichtverfahreu sind aus EP-A-0 234 904 und GB-A-2 189 719 bekannt.

Der Erfindung liegt die Aufgabe zugrunde, eine Vorrichtung zur Lageerfassung der Anschlußkontakte elektrischer oder elektronischer Bauelemente zu schaffen, die eine Hervorhebung der zur Auswertung notwendigen Strukturdetails im Auflichtverfahren mit weitgehender Hintergrundausblendung ermöglicht.

Die Lösung dieser Aufgabe erfolgt gemäß Auspruch 1 durch
- eine Auflagefläche für die Bauelemente in Form einer ebenen Streuscheibe,
- mindestens eine Lichtquelle zur Beleuchtung der Unterseite der Streuscheibe und
- eine auf die Unterseite der Streuscheibe gerichtete Bildaufnahmeeinrichtung.

Der Erfindung liegt die Erkenntnis zugrunde, daß durch Aufsetzen der Bauelemente auf eine gleichmäßig ausgeleuchtete Streuscheibe nur die Anschlußkontakte abgebildet werden, so daß das auf der Unterseite der Streuscheibe erscheinende Bild der Anschlußkontakte mit einer Bildaufnahmeeinrichtung aufgenommen werden kann. Störflächen, die nicht zur Auswertung nötig sind bzw. die Auswertung erheblich beeinträchtigen können, werden unterdrückt. Somit sind mit einer gemäß der Erfindung ausgebildeten Vorrichtung auch Bauelemente auswertbar, deren Strukturdetails auf der Unterseite liegen und im Durchlichtverfahren nicht mehr erfaßt werden können.

Gemäß einer weiteren Ausgestaltung der Erfindung ist auf der Streuscheibe ein Deckglas angeordnet. Hierdurch wird ein Verkratzen der Streuscheibe und damit eine Beeinträchtigung der optischen Eigenschaften der Streuscheibe verhindert.

Gemäß einer besonders bevorzugten Ausgestaltung der Erfindung ist unmittelbar unterhalb der Streuscheibe ein ringförmiger Beleuchtungskörper aus einem lichtstreuenden Material angeordnet, wobei in den Beleuchtungskörper mehrere im Abstand zueinander angeordnete Lichtquellen eingesetzt sind. Hierdurch wird die diffuse Ausleuchtung der Streuscheibe von unten her weiter verbessert. Zusätzliche Vorteile ergeben sich dabei dann, wenn die Innenwandung des Beleuchtungskörpers nach unten hin konisch erweitert ist.

Eine weitere Verbesserung der diffusen Ausleuchtung der Streuscheibe kann dadurch erreicht werden, daß auf der Außenwandung des Beleuchtungskörpers eine Spiegelschicht angeordnet ist. Diese Spiegelschicht kann dabei mit besonders geringem Aufwand durch die Innenwandung eines Gehäuseteils gebildet sein.

Eine besonders robuste und effektive Beleuchtung kann dadurch erzielt werden, daß die Lichtquelle als Infrarot-Lichtquelle ausgebildet ist. Dies kann mit besonders geringem Aufwand dadurch realisiert werden, daß die Lichtquelle durch eine Infrarot-Diode gebildet ist.

Für eine effektive und präzise Lageerfassung der Anschlußkontakte der Bauelemente hat es sich weiterhin als vorteilhaft herausgestellt, wenn die Bildaufnahmeeinrichtung durch ein Objektiv mit nachgeordnetem CCD-Sensor gebildet ist.

Gemäß einer weiteren Ausgestaltung der Erfindung ist vorgesehen, daß zwischen der Streuscheibe und der Bildaufnahmeeinrichtung eine Umlenkspiegel angeordnet ist. Hierdurch wird eine horizontale Anordnung der Bildaufnahmeeinrichtung und damit ein stark reduzierter Raumbedarf ermöglicht.

Bei der Verwendung von Infrarot-Lichtquellen ist es weiterhin vorteilhaft, wenn zwischen der Streuscheibe und der Bildaufnahmeeinrichtung ein Infrarot-Filter angeordnet ist, welches den Durchgang störender Lichtanteile verhindert.

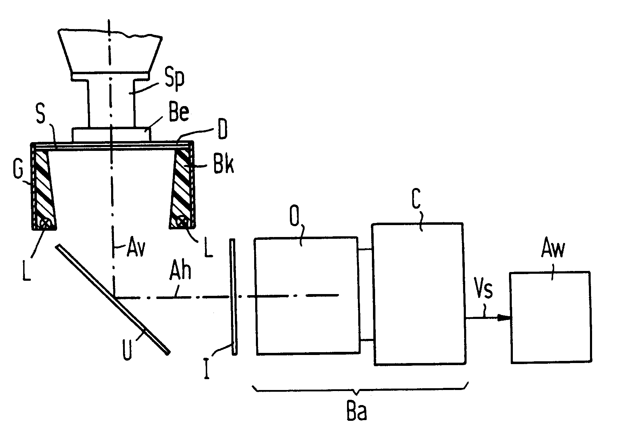

Im folgenden wird ein Ausführungsbeispiel der Erfindung anhand der Zeichnung näher beschrieben.

In der Zeichnung ist die Saugpipette Sp einer des sonst nicht näher dargestellten Bestückkopfes einer automatischen Bestückstation zu erkennen, mit welcher ein SMD-Bauelement Be auf eine als ebene Streuscheibe S ausgebildete Auflagefläche aufgesetzt wurde. Die Oberfläche der beispielsweise aus oberflächenstreuendem Glas bestehenden Streuscheibe S wird dabei durch ein transparentes, klares Deckglas D vor mechanischen Beeinträchtigungen durch die aufgesetzten Bauelemente Be geschützt.

Die Streuscheibe S, die zur besseren Raumausnutzung im Hinblick auf die Form der Bauelemente Be eine rechteckige bzw. quadratische Form aufweist, sitzt auf einem quaderförmigen Gehäuse G, das aus Metall besteht und dessen Innenwandung beispielsweise durch eine galvanisch aufgebrachte Chromschicht als Spiegelfläche wirkt. Innerhalb des Gehäuses G befindet sich ein Beleuchtungskörper Bk aus lichtstreuendem Polyamid, dessen Innenwandung nach unten konisch erweitert ist. In Umfangsrichtung verteilt angeordnet sind in die Unterseite dieses Beleuchtungskörpers Bk zwanzig Lichtquellen L in Form von Infrarot-Dioden eingesetzt. Durch die diffuse Beleuchtung der Streuscheibe S mittels des Beleuchtungskörpers Bk und der Lichtquellen L werden auf der Unterseite der Streuscheibe allein die Anschlußkontakte des darauf aufgesetzten Bauelements Be sichtbar, d.h. andere Strukturdetails oder auch die Kontur der Bauelemente Be werden unterdrückt. Die vertikale optische Achse dieser diffusen Auflichtbeleuchtung ist dabei mit Av bezeichnet. Durch einen unterhalb des Gehäuses G in den Strahlengang eingefügten Umlenkspiegel U wird ein horizontaler Verlauf der nunmehr als Ah bezeichneten optischen Achse erzielt. Nach dem Umlenkspiegel U sind dann nacheinander ein Infrarot-Filter I mit der Bezeichnung RG 830 und eine Bildaufnahmeeinrichtung Ba in den Strahlengang eingefügt. Die Bildaufnahmeeinrichtung Ba besteht dabei aus einem Objektiv O und einem CCD-Sensor C, dessen Videosignal Vs einer Auswerteeinrichtung Aw zugeführt wird. Die Auswerteeinrichtung Aw kann gegebenenfalls ein Korrektursignal für den Bestückvorgang erzeugen oder das auf die Streuscheibe S aufgesetzte Bauelement Be anhand seiner präsise erfaßten Konfiguration der Anschlußkontakte identifizieren.

## Patentansprüche

1. Vorrichtung zur Lageerfassung der Anschlußkontakte elektrischer oder elektronischer Bauelemente, insbesondere von SMD-Bauelementen in automatischen Bestückstationen mit mindestens einer Lichtquelle (L) und einer Bildaufinahmevorrichtung (Ba),
**gekennzeichnet durch**
- eine Auflagefläche für die Bauelemente (Be) in Form einer ebenen Streuscheibe (S),
- wobei die Lichtquelle oder die Lichtquellen die (L) Unterseite der Streuscheibe (S) beleuchten und
- wobei die Bildaufinahmevorrichtung (Ba) auf die Unterseite der Streuscheibe (S) gerichtetet ist.

2. Vorrichtung nach Anspruch 1,
**dadurch gekennzeichnet,**
daß auf der Streuscheibe (S) ein Deckglas (D) angeordnet ist.

3. Vorrichtung nach Anspruch 1 oder 2,
**dadurch gekennzeichnet,**
daß unmittelbar unterhalb der Streuscheibe (S) ein ringförmiger Beleuchtungskörper (Bk) aus einem lichtstreuenden Material angeordnet ist und daß in den Beleuchtungskörper (Bk) mehrere im Abstand zueinander angeordnete Lichtquellen (L) eingesetzt sind.

4. Vorrichtung nach Anspruch 3,
**dadurch gekennzeichnet,**
daß die Innenwandung des Beleuchtungskörpers (Bk) nach unten hin konisch erweitert ist.

5. Vorrichtung nach Anspruch 3 oder 4,
**dadurch gekennzeichnet,**
daß auf der Außenwandung des Beleuchtungskörpers (Bk) eine Spiegelschicht angeordnet ist.

6. Vorrichtung nach Anspruch 5,
**dadurch gekennzeichnet,**
daß die Spiegelschicht durch die Innenwandung eines Gehäuseteils (G) gebildet ist.

7. Vorrichtung nach einem der vorhergehenden Ansprüche,
**dadurch gekennzeichnet,**
daß die Lichtquelle (L) als Infrarot-Lichtquelle ausgebildet ist.

8. Vorrichtung nach Anspruch 7,
**dadurch gekennzeichnet,**
daß die Lichtquelle (L) durch eine Infrarot-Diode gebildet ist.

9. Vorrichtung nach einem der vorhergehenden Ansprüche,
**dadurch gekennzeichnet,**
daß die Bildaufnahmeeinrichtung (Ba) durch ein Objektiv (O) mit nachgeordnetem CCD-Sensor (C) gebildet ist.

10. Vorrichtung nach einem der vorhergehenden Ansprüche,
**dadurch gekennzeichnet,**
daß zwischen der Streuscheibe (S) und der Bildaufnahmeeinrichtung (Ba) ein Umlenkspiegel (U) angeordnet ist.

11. Vorrichtung anch Anspruch 7 oder 8,
**dadurch gekennzeichnet,**
daß zwischen der Streuscheibe (S) und der Bildaufnahmeeinrichtung (Ba) ein Infrarot-Filter (I) angeordnet ist.

## Claims

1. Apparatus for determining the position of the connecting contacts of electrical or electronic components, preferably of SMD components in automatic insertion stations, having at least one light source (L) and an image recording device (Ba), characterised by
- a support surface for the components (Be) in the form of a flat diffusing panel (S),
- the light source or the light sources (L) illuminating the underside of the diffusing panel (S), and
- the image recording device (Ba) being directed onto the underside of the diffusing panel (S).

2. Device according to Claim 1, characterised in that a cover glass (D) is arranged on the diffusing panel (S).

3. Device according to Claim 1 or 2, characterised in that an annular luminaire (Bk) made from a light-diffusing material is arranged immediately below the diffusing panel (S), and in that a plurality of light sources (L) arranged at a distance from one another are inserted into the luminaire (Bk).

4. Device according to Claim 3, characterised in that the inner wall of the luminaire (Bk) is widened conically downwards.

5. Device according to Claim 3 or 4, characterised in that a reflective coating is arranged on the outer wall of the luminaire (Bk).

6. Device according to Claim 5, characterised in that the reflective coating is formed by the inner wall of a housing part (G).

7. Device according to one of the preceding claims, characterised in that the light source (L) is constructed as an infrared light source.

8. Device according to Claim 7, characterised in that the light source (L) is formed by an infrared diode.

9. Device according to one of the preceding claims, characterised in that the image recording device (Ba) is formed by a lens (O) having a downstream CCD sensor (C).

10. Device according to one of the preceding claims, characterised in that a deflecting mirror (U) is arranged between the diffusing panel (S) and the image recording device (Ba).

11. Device according to Claim 7 or 8, characterised in that an infrared filter (I) is arranged between the diffusing panel (S) and the image recording device (Ba).

## Revendications

1. Dispositif pour détecter la position des contacts de raccordement de composants électriques ou électroniques, notamment de composants SMD dans des postes automatiques d'équipement, comportant au moins une source de lumière (L) et un dispositif d'enregistrement d'images (Ba), caractérisé par
- une surface de support pour les composants (Ba), sous la forme d'une plaque diffusante plate (S),
- la ou les sources de lumière (L) éclairant la face inférieure de la plaque diffusante (S), et
- le dispositif d'enregistrement d'images (Ba) étant dirigé vers la face inférieure de la plaque diffusante (S).

2. Dispositif suivant la revendication 1, caractérisé par le fait qu'un verre de revêtement (D) est disposé sur la plaque diffusante (S).

3. Dispositif suivant la revendication 1 ou 2, caractérisé par le fait qu'un corps annulaire d'éclairement (Bk) formé par un matériau diffusant la lumière est disposé directement au-dessous de la plaque diffusante (S) et que plusieurs sources de lumière (L) distantes les unes des autres sont insérées dans le corps d'éclairement (Bk).

4. Dispositif suivant la revendication 3, caractérisé par le fait que la paroi intérieure du corps d'éclairement (Bk) s'élargit vers le bas avec une forme conique.

5. Dispositif suivant la revendication 3 ou 4, caractérisé par le fait qu'une couche réfléchissante est disposée sur la paroi extérieure du corps d'éclairement (Bk).

6. Dispositif suivant la revendication 5, caractérisé par le fait que la couche réfléchissante est formée par la paroi intérieure d'une partie (G) du boîtier.

7. Dispositif suivant l'une des revendications précédentes, caractérisé par le fait que la source de lumière (L) est réalisée sous la forme d'une source de lumière infrarouge.

8. Dispositif suivant la revendication 7, caractérisé par le fait que la source de lumière (L) est formée par une diode à infrarouge.

9. Dispositif suivant l'une des revendications précédentes, caractérisé par le fait que le dispositif d'enregistrement d'images (Ba) est formé par un objectif (O) en aval duquel est disposé un capteur CCD (C).

10. Dispositif suivant l'une des revendications précédentes, caractérisé par le fait qu'un miroir de déviation (U) est disposé entre la plaque diffusante (S) et le dispositif d'enregistrement d'images (Ba).

11. Dispositif suivant la revendication 7 ou 8, caractérisé par le fait qu'un filtre à infrarouge (I) est disposé entre la plaque diffusante (S) et le dispositif d'enregistrement d'images (Ba).
